Europäisches Patentamt

European Patent Office

Office européen des brevets

(19)

(11) **EP 0 862 728 B1**

(12) **EUROPÄISCHE PATENTSCHRIFT**

(45) Veröffentlichungstag und Bekanntmachung des Hinweises auf die Patenterteilung:
**22.01.2003 Patentblatt 2003/04**

(51) Int Cl.⁷: **G01D 5/347**, G01D 5/249, H03M 1/00

(21) Anmeldenummer: **97910311.6**

(22) Anmeldetag: **19.09.1997**

(86) Internationale Anmeldenummer:
**PCT/EP97/05142**

(87) Internationale Veröffentlichungsnummer:
**WO 98/013669 (02.04.1998 Gazette 1998/13)**

(54) **DREHWINKELSENSOR MIT CCD-ZEILE MIT VERBESSERTER MESSGENAUIGKEIT**

ROTATIONAL ANGLE SENSOR USING A CCD LINE WITH ENHANCED MEASURING PRECISION

CAPTEUR D'ANGLE DE ROTATION A LIGNE DE CCD OFFRANT UNE PRECISION DE MESURE ACCRUE

(84) Benannte Vertragsstaaten:
**DE FR GB SE**

(30) Priorität: **23.09.1996 DE 19638912**
**23.09.1996 DE 19638911**

(43) Veröffentlichungstag der Anmeldung:
**09.09.1998 Patentblatt 1998/37**

(73) Patentinhaber: **Valeo Schalter und Sensoren GmbH**
**74321 Bietigheim-Bissingen (DE)**

(72) Erfinder:
• **BENZ, Jürgen**
**D-74353 Besigheim (DE)**
• **RUFF, Achim**
**D-74399 Walheim (DE)**

(74) Vertreter: **Dreiss, Fuhlendorf, Steimle & Becker Patentanwälte**
**Postfach 10 37 62**
**70032 Stuttgart (DE)**

(56) Entgegenhaltungen:
**EP-A- 0 377 097      EP-A- 0 430 288**
**EP-A- 0 660 085      DE-A- 4 013 936**
**DE-A- 4 224 654      GB-A- 2 126 444**
**GB-A- 2 162 635      US-A- 5 129 725**

• **HALLOIN ET AL.: "Hydraulische Linearantriebe in Werkzeugmaschinen" VDI - ZEITSCHRIFT, Bd. 132, Nr. 1, April 1990, DÜSSELDORF, DE, Seiten 6-13, XP000127500**
• **TOMLINSON: "Absolute-type shaft encoder using shift register sequences." ELECTRONICS LETTERS, Bd. 23, Nr. 8, 9.April 1987, STEVENAGE, HERTS., GR. BRITAIN, Seiten 398-400, XP002051828**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft einen Positionssensor, insbesondere Drehwinkelsensor mit CCD-Zeile gemäß den Merkmalen des Oberbegriffs des Anspruchs 1

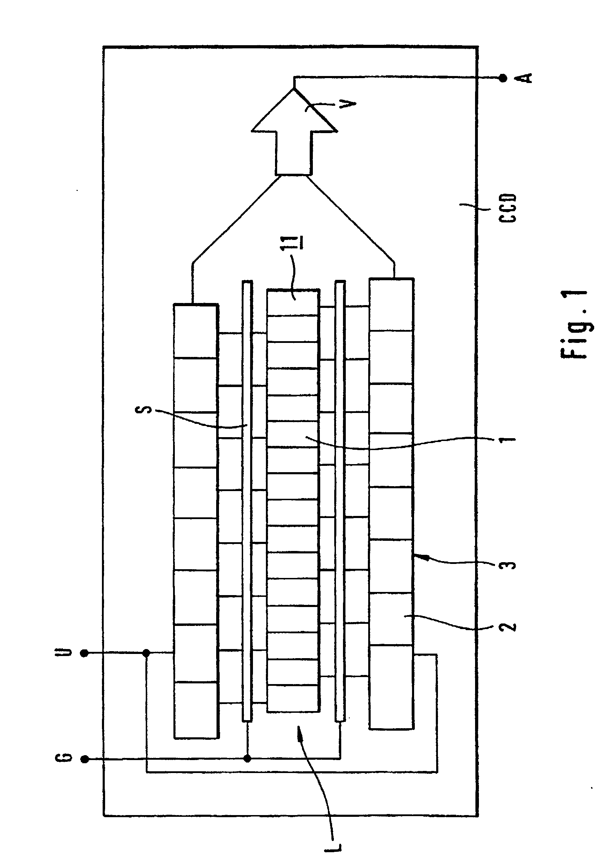

Aus HALLOIN ET AL "Hydraulische Linearantriebe in Werkzeugmaschinen", VDI-Zeitschrift, Bd. 132, Nr. 1, April 1990, Düsseldorf, DE, Seiten 6 bis 13, XP000127500 ist ein derartiger Positionssensor bekannt. Ein derartiger Sensor ist auch in dem Application Brief der Firma Texas Instruments unter dem Titel "Alinear products TSL 214 integrated Opto-Sensor" in Verbindung mit den dort gezeigten Figuren 1 bis 5 beschrieben worden. Einzelheiten zu dem integrierten Opto-Sensor TLS 215 wurden in der Produktbeschreibung von der Firma Texas Instruments in dem Kapitel 4.19 bis 4.28 und der Überschrift "TSZ 215, 128x1 integrated Opto-Sensor" unter der Nummer SOES 005A-Mai, 1993 veröffentlicht.

Die bekannte CCD-Zeile besitzt eine Reihe von nebeneinander angeordneten Sammelelementen, die Pixels genannt werden. Diese Pixels werden ausgehend von einem Ausgangszustand, in dem die Sammelelemente entleert sind, in Abhängigkeit von dem auf sie auftreffenden Lichtstrom aufgeladen. Die aufgrund der auf die Pixels auftretenden Lichtverteilung unterschiedliche Ladung entspricht unterschiedlichen Spannungswerten an den Pixels. Zu einem vorbestimmten sich periodisch wiederholenden Zeitpunkt werden die Spannungen aller Pixel auf zugeordnete Speicherelemente eines Schieberegisters parallel übertragen, so dass die Spannungsverteilung auf den einzelnen Speicherelementen in dem Schieberegister dem den einzelnen zugehörigen Pixels zugeführten Lichtstrom entspricht. Durch eine geeignete Elektronik werden danach die Sammelelemente (Pixels) auf ihren leeren Ausgangszustand zurückgeschaltet und durch die auftreffende Beleuchtung wieder aufgeladen, während gleichzeitig schrittweise die Spannungswerte aus den Speicherelementen des Schieberegisters seriell ausgelesen und die analogen Werte in digitale Werte umgesetzt werden. Es stehen also beispielsweise schließlich 64 bzw. 128 Digitalwerte zur Verfügung, welche den auf den zugehörigen Pixels während des vorangegangenen Zeitabschnitts aufgetroffenen Lichtstrom beschreiben. Mit Hilfe eines codierte Blendenöffnungen aufweisenden Trägers, bei dem die durchgelassene Lichtverteilung der Position des Trägers gegenüber der CCD-Zeile entspricht, ist es also möglich, aufgrund der gemessenen Licht- bzw. Spannungsverteilung auf die augenblickliche Lage des Trägers beim Messvorgang zu schließen. Das gilt in dem beschriebenen Anwendungsbeispiel für den Drehwinkel einer codierten Scheibe, aber auch für die Beschreibung der Längsposition eines Trägers, wenn dort die lineare Position des Trägers mit Hilfe einer optisch durchlässigen Codierung beschrieben ist. Die Verwendung derartig optisch durchlässiger Codierungen wurde bereits in der 195 32 903.1 beschrieben. Der wesentliche Unterschied zu der beschriebenen Codierscheibe besteht darin, dass der die Scheibe durchdringende Lichtstrom nicht mit Hilfe einer CCD-Zeile, sondern mit Hilfe eines oder mehrerer Dioden gemessen wird.

Nachteilig bei einer derartigen Sensoreinrichtung ist es, dass sich während eines Abtastzeitraums der Lichtstromverteilung des durch die Codescheibe hindurchtretenden Lichtstroms, die Codescheibe bei entsprechend schneller Lenkraddrehung sich erheblich verschiebt. Das heißt, die Zuordnung einzelner lichtdurchlässiger Codierfelder auf der Codescheibe gegenüber den angestrahlten Pixels verändert sich, so dass sich die Lichtstromverteilung des auftreffenden Lichts während eines Sammelzeitraums verändert. Als Folge davon ergeben sich unscharfe Grauwertübergänge, so dass die Abbildung der durch die Codescheibe bedingten Lichtverteilung auf der CCD-Zeile verwaschen ist. Um die unscharfen Grauwertübergänge zu reduzieren, kann man versuchen, die Zahl der Codeworte und damit die Codierung möglichst groß und grob zu halten. Eine grobe Codierung dient auch zur Reduzierung der Schmutzsensibilität und zur einfachen Codescheibenherstellung.

Aus der GB-A-2 162 635 ist es bekannt, die Lichtquelle mit gepulstem Licht zu betreiben, um diese besser vom Tageslicht unterscheiden zu können.

Die vorliegende Erfindung hat sich in Verbesserung des bekannten Systems die Aufgabe gestellt, die Grauwertübergänge durch andere Maßnahmen stark zu verbessern und so die Empfindlichkeit des Sensors zu erhöhen.

Die Aufgabe wird durch die sich aus dem kennzeichnenden Teil des Anspruchs 1 ergebende Merkmalskombination gelöst.

Die Erfindung besteht im Prinzip also darin, die Dauer der Beleuchtung des Codierelementes, also bei einem Drehwinkelsensor der Codierscheibe stark zu verkürzen. Damit wird das Codierelement nur kurzzeitig angestrahlt, etwa in der Form eines Stroboskops. Um auch aufgrund des verkleinerten Lichtstroms die Lage des Codierelementes nach dem Aufladevorgang eindeutig bestimmen zu können, wird der Einschaltzeitpunkt der Lichtquelle mit dem Abtastzeitpunkt und dem Auslesetiming synchronisiert.

Nachteilig bei der Erfindung kann es dabei sein, dass der abgegebene Lichtstrom und damit die von den Sammelelementen aufgenommene Ladung vergleichsweise klein wird. Abhilfe lässt sich hier durch die Merkmalskombination nach Anspruch 2 schaffen. Dabei wird die Lichtquelle so betrieben, dass über die Gesamtdauer die Nennleistung erreicht wird. Es werden somit anders ausgedrückt durch die Lichtquelle kurzzeitig starke Lichtmengen abgegeben.

Versuche haben ergeben, dass die zyklische Einschaltzeit entsprechend den Merkmalen nach Anspruch 3 kleiner als 5 % der Zykluszeit und noch besser kleiner als 1 % der Zykluszeit sein sollte.

Um aufgabengemäß die Messgenauigkeit des Sensors noch weiter zu verbessern, schlägt die Erfindung die Merkmalskombination nach Anspruch 4 vor. Danach wird das Codierelement (d.h. bei einem Drehwinkelsensor die Codierscheibe) mit Codierfeldern versehen, welche nur zwei Zuständen entsprechen. Das heißt, das Codierelement ist mit Codierfeldern versehen, die entweder lichtundurchlässig sind oder eine definierte Lichtdurchlässigkeit haben. Diese Lichtdurchlässigkeit entspricht den Zuständen 0 und 1 eines mehrschrittige Codes. Dabei ist die geometrische Anordnung derart getroffen, dass durch ein Codierfeld immer mehrere Speicherelemente (Pixel) abgedeckt werden oder durch Lichtstrom beaufschlagt werden. An sich wäre es auch denkbar, jedem Pixel ein eigenes Codierelement zuzuordnen. Der hier gemachte Vorschlag dient der größeren Sicherheit, um in Grenzfällen entscheiden zu können, ob ein hinreichender Lichtstrom zu einer Pixelgruppe geschickt wurde oder nicht. Damit wird die Entscheidung, ob ein lichtdurchlässiges oder undurchlässiges Codierfeld vorgelegen hat, sehr viel sicherer getroffen, als wenn nur ein einziges Pixel je Codierfeld vorgesehen ist. Weiterhin ist es so, dass mehrere Codierfelder (beispielsweise 12 Codierfelder) durch die CCD-Zeile abgetastet und von dem Sensor bewertet werden, wobei wieder jedem Codierfeld mehrere Pixel zugeordnet sind, beispielsweise zwischen 10 und 11 Pixel (das ergibt sich beispielsweise bei der Verwendung eines 12schrittigen Maximalcodes und der Verwendung einer Codierzeile mit 128 Pixel). Die Verwendung einer größeren Anzahl von Pixel je Codierelement bzw. Codierschritt eines mehrschrittigen Codes hat die vorteilhafte Wirkung, dass sich ein lichtunterdrückendes Codierfeld oder ein lichtstromdurchlassendes Codierfeld auch dann noch erkennen lässt, wenn die die Flanke des Abbildes bestimmenden Pixelspannungen Zwischenwerte einnehmen. Dies ist beispielsweise dann der Fall, wenn der Rand eines Codierfeldes ein Pixel beispielsweise nur teilweise abdeckt oder wenn Streustrahlungen an den Rändern des Codierfeldes die an den Pixeln ablesbaren Flanken verzerren.

Soweit der erfindungsgemäße Positionssensor zur Drehwinkelbestimmung insbesondere der Bestimmung des Drehwinkels eines Lenkrads verwendet wird, empfiehlt sich in Weiterbildung der Erfindung die Verwendung der Merkmalskombination nach Anspruch 5. Im Prinzip kann somit das Codierelement aus einer Codierscheibe gebildet sein, auf dem ähnlich wie Tortenstücke einer Torte einander folgend in durch den Code vorgeschriebener Reihenfolge lichtdurchlässige und lichtundurchlässige Kreissektoren aneinandergrenzend angeordnet sind. Dabei können entsprechend der Merkmalskombination nach Anspruch 6 die Codierfelder auf einem Kreisring einander folgen, ähnlich wie wenn man aus den genannten Tortenstücken nur diejenigen Abschnitte herausschneidet, welche innerhalb des Kreisrings liegen. Für diesen Fall empfiehlt es sich, die CCD-Zeile tangential zum Kreisring auszurichten und oberhalb oder unterhalb der Codierscheibe über dem Kreisring anzuordnen. Da die Zeile im wesentlichen eine Gerade bildet, während der Kreissektor gekrümmt ist, hängt der von den durchlässigen Codierfeldern durchgelassene Lichtstrom auch von der Lage der zugeordneten Pixel auf der Zeile ab. Hier lassen sich allerdings entsprechende Korrekturen anbringen, die die regelmäßige Lichtstromverminderungen ausgleichen. Als Codierung empfiehlt sich in Weiterbildung der Erfindung die Merkmalskombination nach Anspruch 6. Danach wird ein Maximalcode gewählt. Dieser Maximalcode zeichnet sich dadurch aus, dass die auf einem Kreisbogen angeordnete in sich geordnete Folge von Codierelementen zu sich nicht wiederholenden codierten Werten (Worten) führt. Anders ausgedrückt können beispielsweise auf einem Kreisring 180 Codierfelder untergebracht sein, wobei immer 12 hintereinanderfolgende Codeelemente ein zwölfschrittiges Codewort ergeben. Wird die Kreisscheibe um einen Winkel von 2°, also um ein Codeelement verschoben, so ergibt sich ein neues Codewort. Alle 180 möglichen Codeworte sind voneinander unterschieden, wobei immer nur bei einander benachbarten Codierfeldern ein neuer erster Schritt hinzugefügt und der letzte Schritt weggelassen wird (bzw. umgekehrt bei entgegengesetzter Drehrichtung).

Um eine größere Redundanz zu erhalten, geht man entsprechend der Merkmalskombination nach Anspruch 8 von einem Maximalcode von 4.096 Codeworten aus, wobei nur ein vergleichsweise kurzer Abschnitt dieser Codewortfolge verwendet wird, die über 180 Codeworte reicht. An sich ist man frei, welchen Abschnitt mit 180 Codeworten man aus der Gesamtfolge von 4.096 Codeworten man herausschneidet und auf der Codescheibe kreisringförmig anlegt. Bevorzugt wird aber nach einer Strategie vorgegangen, welche durch die Merkmale nach Anspruch 9 beschrieben wird. Gemäß der Merkmalskombination nach Anspruch 6 wird empfohlen, bei einer bestimmten Ausgestaltung des Codierfeldes die CCD-Zeile tangential zu einem Kreisring anzuordnen.

Eine andere Möglichkeit zur Anordnung der Codierzeile ist in der Merkmalskombination nach Anspruch 10 angegeben. Danach wird die Codierzeile radial angeordnet. Hierdurch ist es notwendig, dass auch die Schritte des von der Codierzeile jeweils ausgelesenen mehrschrittigen Codewortes in radialer Anordnung zueinander liegen. Eine derartige radiale Anordnung kann beispielsweise dann zweckmäßig sein, wenn der zur Verfügung stehende Umfang des Kreisrings vergleichsweise klein ist wie bei einer Mantelfläche eines Lenkstocks. Es müssen aber die radial angeordneten Codeworte nicht auf der Mantelfläche eines Hohlzylinders angeordnet sein, sie können auch radial auf einer Kreisscheibe verlaufen. In beiden Fällen wird man vorzugsweise einen Gray-Code verwenden.

Um bei der Auswertung der gelesenen Codeworte Mikroprozessoren verwenden zu können, empfiehlt sich in Weiterbildung der Erfindung die Merkmalskombination nach Anspruch 11. Danach werden die ausgewerteten Codeworte durch ein Mikroprozessor ausgewertet, indem beispielsweise auf Fehler überprüft wird und aufgrund des gefundenen Codeworts der gemessene Winkel bestimmt wird.

Weiter oben wurde schon erläutert, dass ein Schritt eines mehrschrittiges Codes nicht durch ein einziges Pixel bestimmt ist, sondern praktisch die Kurvenkontur dieses Schrittes durch die Spannungen mehrerer Pixel umschrieben wird.

Während nun also bei Kenntnis des durch die 128 Pixel bestimmten Kurvenverlaufes das entsprechende (12schrittige) Codewort gefunden und so der Winkelwert auf 2° genau grob bestimmt werden kann, empfiehlt sich zur Bestimmung des Winkels mit größerer Genauigkeit die Verwendung der Merkmalskombinationen nach Anspruch 12. Danach wird nicht nur das mehrschrittige Codewort allgemein bestimmt, sondern auch seine Lage gegenüber dem Anfang bzw. dem Ende der CCD-Zeile. Hierdurch ergibt sich eine erhebliche Vergrößerung der Genauigkeit, mit der der gerade gemessene Winkel bestimmt werden kann. Stellt man nämlich fest, dass die Kante eines oder mehrerer Schritte z.B. um 1 Pixel gegenüber der Normalstellung nach rechts oder links verschoben sind, so lässt sich hierdurch die gemessene Winkelstellung mit 10facher Genauigkeit bestimmen, da etwa 10 Pixel einen Codierschritt beschreiben, der sich durch das Codierfeld ergibt. Dabei kann man mit unterschiedlichen Strategien vorgehen. So kann beispielsweise die Verschiebung der Flanken oder die Verschiebung des Maximums eines oder mehrerer Codeschritte gegenüber einer Normallage bestimmt werden.

Mit entsprechenden Auswertealgorithmen (Software) lässt sich auch eine Auflösung im Sub-Pixelbereich erreichen. Zur Erhöhung der Genauigkeit kann auch der Kontrast zwischen der Wiedergabe lichtdurchlässiger gegenüber lichtundurchlässiger Codierfelder bestimmt werden. Durch Verschmutzung der Codefelder durch teilweises Zusetzen der lichtdurchlässigen Felder mit Schmutz kann hier eine Reduzierung der Differenzwerte (Kontrast) ermittelt werden. Sinkt der Kontrast unterhalb einer bestimmten Schwelle, so kann das bedeuten, dass die Scheibe zu reinigen bzw. auszuwechseln ist. Die Merkmalskombination nach Anspruch 13 schlägt darüber hinaus vor, die Sendeleistung der Lichtquelle durch Erhöhung der Sendeleistung oder Verlängerung der Sendedauer anzupassen, so dass der gewünschte Kontrast wieder hergestellt wird.

Dieses Prinzip ist bei allen mit CCD-Zeile arbeitenden Sensoren anwendbar und stellt somit eine weitere unabhängige Lösung in der Verbesserung der Empfindlichkeit des Sensors dar. Bei der Auswertung der von der CCD-Zeile abgegebenen Analogwerte ist zum einen der jeweilige Analogwert in eine Digitalzahl umzuwandeln, welche den Amplitudenwert der Pixelspannung beschreibt und weiterhin aufgrund der Digitalzahlen der gemessene Drehwinkelwert zu berechnen mit all den zusätzlichen Berechnungen wie Fehlerkorrektur und anderen Prüfschritten. Da die Umwandlung von Analog- in Digitalwert parallel zur Berechnung des Winkelwertes geschehen kann, empfiehlt sich in Weiterbildung der Erfindung die Verwendung der Merkmalskombination nach Anspruch 14. Diese Maßnahmen können für alle Sensoren der sich aus Anspruch 1 ergebenden Gattung angewendet werden. Ist also ein Digitalwert durch Umrechnung eines Analogwerts gebildet worden, so wird mittels eines Interrupts die Umrechnung des nächsten Wertes veranlasst und daraufhin mit der Berechnung des Winkelwertes durch das Rechenweck fortgefahren.

Die Erfindung betrifft, wie schon eingangs erwähnt, einen Drehwinkelsensor insbesondere Lenkwinkelsensor für Kraftfahrzeuge. Derartige Sensoren werden benötigt für z.B. Regeleinrichtungen zur Regelung der Fahrstabilität von Kraftfahrzeugen. Bei derartigen Sensoren ist regelmäßig mindestens eine kreisförmig angeordnete Codespur auf einem Codierelement vorgesehen, wobei auf der Codespur sich nicht wiederholende Codeworte angebracht sind. Das Codierelement ist mit dem Lenkstock des Fahrzeugs gekoppelt. Auf diese Weise kann von der Drehbewegung des Codierelementes auf die Schwenkbewegung der Fahrzeugräder geschlossen werden.

Da bei jeder Drehstellung des Codierelementes nur ein bestimmtes Codewort durch die Leseeinrichtung gelesen werden kann, kann aufgrund des gefundenen Codeworts auf die Stellung der Codierscheibe und damit die Winkelstellung der Lenkräder des Fahrzeugs geschlossen werden. Als Schwierigkeit hat sich herausgestellt, dass das Lenkrad mehrere Umdrehungen machen muss, um die insgesamt mögliche Schwenkbewegung der Lenkräder durchzuführen. Es ist somit nicht nur wichtig, die absolute Drehbewegung des Lenkrades zu kennen, sondern es müssen auch die Anzahl der Umdrehungen des Lenkstocks gegenüber einer Nullstellung bekannt sein, um den Schwenkwinkel der Lenkräder eindeutig bestimmen zu können. Hierzu ist in der P 8636 der Anmelderin schon vorgeschlagen worden, ein Schrittschaltwerk mit Zähler vorzusehen, welches in Abhängigkeit von den durch das Codierelement durchgeführten Umdrehungen schrittweise vorwärts oder rückwärts geschaltet wird, so dass die Zahl der gegen eine Nullstellung bestehenden Umdrehungen des Codierelementes stets bekannt ist.

Bei einer Weiterbildung der Erfindung gemäß Anspruch 17 kann auf ein besonderes Schrittschaltwerk zur Bestimmung der gerade gültigen Umdrehungszahl verzicht und die Messung der Umdrehung in den eigentlichen Drehwinkelsensor zu integriert werden. Die Weiterbildung besteht im Prinzip darin, mehrere quer zur Bewegungsrichtung der Leseeinrichtung angeordnete Codespuren vorzusehen und die Leseeinrichtung in Abhängigkeit von der gerade gültigen Umdrehungszahl zu den einzelnen Codespuren zu befördern. Dabei kann durch die gerade abgetastete Codespur die augenblicklich gültige Umdrehung festgelegt sein. Dies kann dadurch geschehen, dass innerhalb jeder Spur ein besonderer Code abgetastet werden kann, der einen Hinweis auf die Umdrehungszahl gibt. Es ist aber auch möglich, einen fortlaufenden (beispielsweise Maximalcode) derart über alle Spuren zu verteilen, dass mit Hilfe der entschlüsselten Codeworte nicht nur der absolute Drehwinkel, sondern gleichzeitig auch noch die Umdrehungszahl festgelegt ist.

Eine besonders einfache Anordnung der Codespuren ergibt sich durch die in Anspruch 18 angegebene Merkmalskombination. Danach werden die einzelnen Codespuren spiralförmig miteinander verbunden. Dies kann dadurch geschehen, dass bei einer bestimmten absoluten Winkelstellung die Leseeinrichtung in Abhängigkeit von ihrer Drehbewegung eine Spur höher oder niedriger befördert wird. Besonders einfach wird die Gesamtcodespur aber dann, wenn sie eine durchgehende spiralförmige Spur bildet, so dass die Bewegungsrichtung der Leseeinrichtung abgesehen bei Umschaltung von der Vorwärts- nach Rückwärtsbewegung keine größere Änderung erfährt. Die Codespur kann dabei entsprechend der Merkmalskombination nach Anspruch 19 spiralförmig sowohl auf einer Kreisscheibe oder auch auf einer Mantelfläche eines Zylinders angeordnet sein. Es kann dabei sowohl das Durchlichtprinzip als auch das Reflexionsprinzip angewendet werden. Soweit der Zylinder kein Hohlzylinder ist, ist das Reflexionsprinzip anzuwenden, beispielsweise dann, wenn die Codespur spiralförmig auf den Lenkstock aufgebracht ist.

Es lassen sich eine große Anzahl von unterschiedlichen Transportmitteln zum Transport der Leseeinrichtung angeben. Besonders vorteilhaft hat sich dabei die in Anspruch 20 beschriebene Transporteinrichtung herausgestellt, indem die Führungsmittel direkt an Codierelement und Leseeinrichtung angeordnet sind. Dabei empfiehlt sich insbesondere die Ausgestaltung gemäß Anspruch 21, bei der das dem Codierelement zugeordnete Führungsmittel parallel zur spiralförmigen Codespur verläuft. Besonders einfach wird die Konstruktion durch die Maßnahmen nach Anspruch 22. Insbesondere dann, wenn die Codierung auf dem Codierelement nach dem Durchlichtprinzip arbeitet. Es ist dabei zweckmäßig, die Codierung, d.h. die Durchbrüche auf der Codescheibe am Boden der Führungsnut anzuordnen, da dort die Scheibe ohnedies eine geringere Dicke hat. Gleichzeitig können die Leseelemente wie beispielsweise Dioden, CCD-Zeile, Hall-Element oder ähnliches an der dem Nutboden zugewandten Fläche der Leseeinrichtung angeordnet sein, so daß sie seitlich abgeschirmt direkt unterhalb der die Codierung bildenden Durchbrüche sich befinden.

Um nicht eine spezielle Codierung hinsichtlich der gerade eingenommenen Umdrehungszahl festlegen zu müssen, empfiehlt sich in Weiterbildung der Erfindung die Merkmalskombination nach Anspruch 23. Danach ist die Codierung durch einen fortlaufenden, sich über die gesamte Spirale erstreckenden Maximalcode gebildet. Da sich keines der Codeworte wiederholt, kann innerhalb dieser mehrschrittigen Codeworte auch gleichzeitig nicht nur der Absolutwinkel, sondern auch die entsprechende Umdrehungszahl verschlüsselt werden.

Besonders einfach wird die Leseeinrichtung bei Verwendung einer CCD-Zeile. Die Leseelemente wie beispielsweise Dioden oder Hall-Element können aber auch auf zueinander parallel laufenden Spuren gerichtet sein, so dass sich hierdurch die absolute Drehlage aber auch die relative Drehlage des Codeelements gegenüber den Leseelementen bestimmen lässt.

Ein Ausführungsbeispiel der Erfindung wird nachfolgend anhand der Zeichnung erläutert. Darin zeigt:

Fig. 1      den schematischen Aufbau einer CCD-Zeile

Fig. 2      in symbolischer Darstellung den Aufbau eines erfindungsgemäßen Drehwinkelsensors

Fig. 3      den Aufbau einer Codierscheibe für einen Drehwinkelsensor mit tangential ausgerichteter CCD-Zeile

Fig. 4      einen Ausschnitt aus einem Maximalcode, wie er auf der Scheibe nach Fig. 3 angeordnet ist

Fig. 5      die digitalisierten Pixel-Spannungen

Fig. 6      die differenzierten Spannungswerte nach Fig. 5 und

Fig. 7      die Ausformung eines 12schrittigen Codes, wobei die von den einzelnen Pixeln abgeleiteten Null- und 1Werte jeweils gleich groß sind und die Kanten der Impulse durch die Wendepunkte der Impulssteigung nach Fig. 5 bestimmt sind.

Fig. 8      eine Codescheibe mit darunter tangential angeordneter CCD-Zeile und

Fig. 9      eine Transporteinrichtung zum Transport der CCD-Zeile in radialer Richtung.

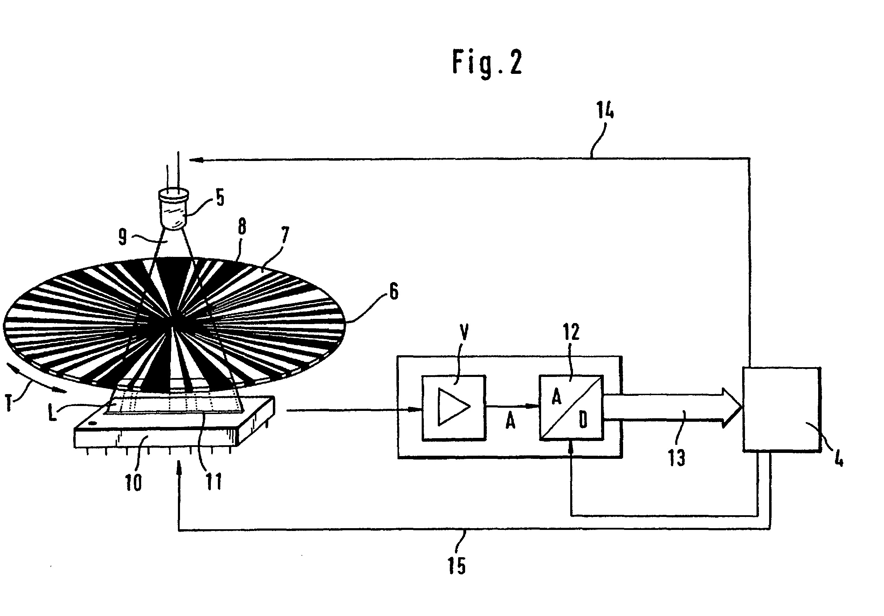

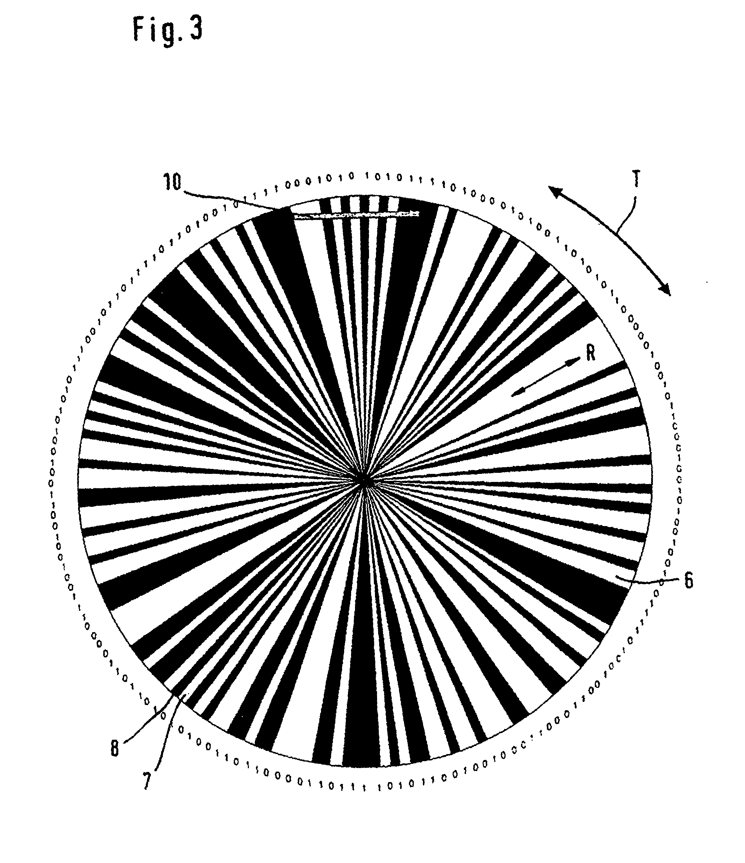

Fig. 1 zeigt das Schema, wie es bereits im Zusammenhang mit den eingangs genannten Literaturstellen beschrieben ist. In Fig. 1 sind beispielsweise 16 lichtempfindliche Pixel 1 dargestellt, die von einem Lichtstrom L beaufschlagt werden. Dabei ist die Verteilung des auf die einzelnen Pixel 1 auftreffenden Lichtstroms abhängig von der Codierung eines Codierelementes, die im vorliegenden Beispiel als Codierscheibe (siehe Fig. 2 und 3) ausgestaltet ist. Die Lichtverteilung des Lichtstroms L hängt von dem augenblicklich gültigen Codewort auf der Codierscheibe ab, welches wiederum von dem Drehwinkel der Codierscheibe abhängt. In Abhängigkeit von der Verteilung des Lichtstroms L über den einzelnen Pixels 1 wird dort eine entsprechende Ladung gesammelt, die wiederum zu einer zugehörigen Spannung an dem Ausgang der Pixel führt. Nach einem vorgegebenen Zeitabschnitt wird über die Anschlüsse G und U das Gatter S geöffnet, so daß die Spannungswerte der einzelnen Pixel 1 zu den zugehörigen Speicherpositionen 2 des Schieberegisters 3 parallel übertragen werden. Damit steht ein Abbild der Spannungswerte der Pixel in den zugehörigen Speicherpositionen des Schieberegisters 3. Anschließend werden die Pixel 1 z.B. durch Entladung in ihre Ausgangslage zurückgestellt und erneut dem Lichtstrom L ausgesetzt. Während dieser Beleuchtungszeit wird das Schieberegister 3 schrittweise seriell zur Auslesestufe V ausgelesen und steht an dem Ausgang A zur Verfügung (Fig. 2). Nachdem das Schieberegister entleert ist, können die sich inzwischen gebildeten Spannungswerte der Pixel 1 wiederum parallel in das Schieberegister 3 übertragen werden, wo sie dann wiederum seriell ausgelesen werden.

Fig. 2 zeigt in symbolischer Darstellung die Wirkungsweise des Sensors. Die in Abhängigkeit von dem Rechner 4 gepulste Infrarot-LED als Lichtquelle 5 strahlt ein Lichtband auf das Codierelement 6, welches als Codierscheibe ausgestaltet ist. Die Codierscheibe weist sektorförmige lichtdurchlässige Felder 7 und lichtundurchlässige Felder 8 auf, wobei 12 dieser nebeneinanderliegenden Felder jeweils ein 12schrittiges Codewort ergeben. Der Code auf der Codierscheibe 6 ist ein Maximalcode, d.h. die einzelnen Codeworte entstehen durch ein 12 Schritte aufweisendes Fenster. Dreht sich die Codescheibe 6 um einen Schritt, so ergibt sich ein neues Codewort dadurch, daß ein neuer erster Schritt hinzugekommen ist und der letzte Schritt des vorangegangenen Wortes weggelassen wurde. Keines der möglichen Codeworte auf der Scheibe wiederholt sich. Die Codierfelder 7,8 sind entweder durchlässig oder undurchlässig, wobei mehrere Codierfelder gleicher Durchlässigkeit nebeneinander liegen können und so einen entsprechend großen Kreissektor ergeben. Das flächige Lichtbündel 9 trifft auf die Codierscheibe 6 auf und es werden Teile des Lichtbündels durch entsprechende Codierfelder 7 durchgelassen, während andere Teile des Bündels nicht zu der CCD-Zeile 10 durchgelassen werden. Es ergibt sich somit eine Lichtverteilung L auf der CCD-Zeile 10, die auf die Pixelreihe 11 auftrifft und die Pixel entsprechend auflädt. Die Pixelspannungen werden dann wie schon im Zusammenhang mit Fig. 1 beschrieben, periodisch auf ein Schieberegister umgeladen und dann seriell über eine Auslesestufe V einem Analog-/Digitalwandler 12 zugeführt. Dieser Analog-/Digitalwandler kann noch in die CCD-Zeile 10 integriert sein, wodurch sich ein sog. integrierter Opto-Sensor ergibt. Verwendung des Mikro-Controller-internen A/D-Wandler ist ebenfalls möglich.

Der digitalisierte Ausgangswert 13 des Wandlers 12 wird dem Rechner 4 zugeführt, welcher wiederum den pulsweisen Betrieb der LED 5 als auch die Rückstellung der Pixelzeile 11 sowie der Ausspeicherung aus dem nicht im einzelnen dargestellten Schieberegister über Steuerleitungen 13,14 steuert. Aus den Digitalwerten am Ausgang 13 wird dann schließlich das entsprechende Codewort im Rechner 4 erkannt und daraus wiederum der gemessene Drehwinkel, der Codierscheibe 6 grob bestimmt. Eine Feinwickelbestimmung ergibt sich durch Auswertung der Kanten (0-1-Übergänge) oder Schwerpunkte der 0- bzw. 1-Felder.

Fig. 3 zeigt die Codierscheibe 6 mit den einzelnen Codierfeldern 7,8, die 0- und 1-Werten entsprechen. Auf der der Lichtquelle 5 gegenüberliegenden Seite ist wie schon in Fig. 2 angedeutet, in tangentialer Richtung die CCD-Zeile 10 angeordnet und zwar derart, daß von ihr ein 12schrittiger Code gelesen werden kann. Unterstellt man, daß die CCD-Zeile 10 mit 128 Pixel versehen ist und daß als Grobmessung mittels des 12schrittigen Codes 180 unterschiedliche Winkelwerte beschrieben werden können, so entsprechen jedem Schritt des Codeworts etwas 10 Pixel. In Fig. 3 ist der verwendete Maximalcode angedeutet, in dem die einzelnen Schritte, die wiederum Codierfeldern 7,8 entsprechen, mit 0 oder 1 bezeichnet wurden (0 entspricht undurchlässig, 1 entspricht durchlässig). Wenn sich die Scheibe unterhalb der CCD-Zeile 10 dreht, erscheint über dem Beginn der Zeile ein neuer Schritt, während am Ende der Zeile der letzte Schritt keine Wirkung mehr auf die Zeile hat.

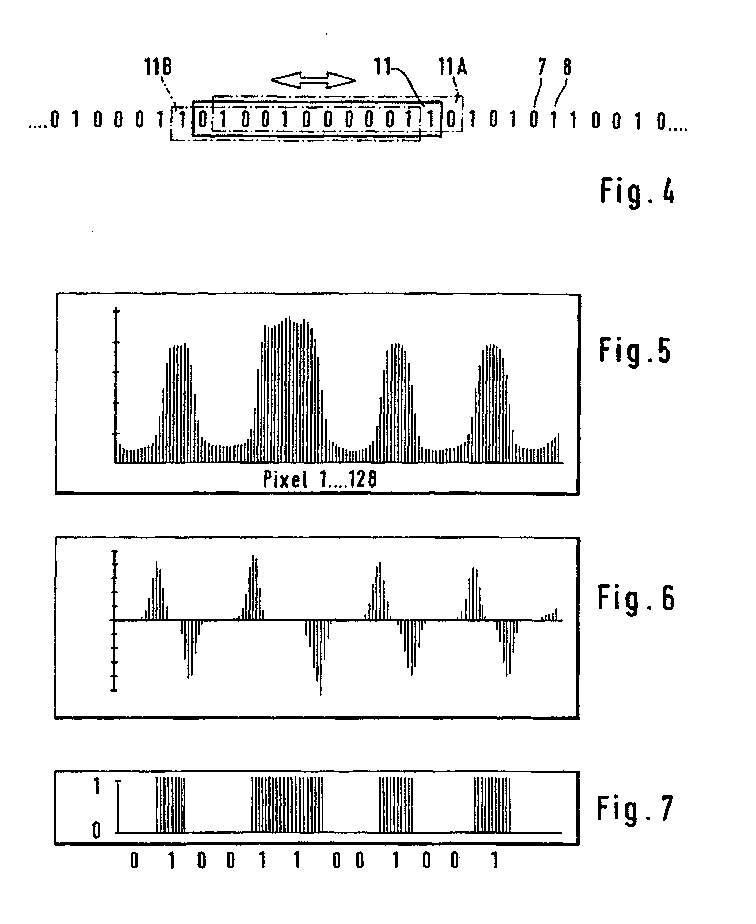

In Fig. 4 ist die Wirkung des Maximalcodes angedeutet. Dabei schiebt sich die Folge der Codierfelder 7,8 beim Drehen der Codierscheibe 6 unter der Pixelzeile 11 nach rechts oder links je nach Drehrichtung der Codierscheibe 6. In der Zeichnung stellt sich dies als Verschiebung des Pixelfensters nach rechts oder links in die Lage 11a oder 11b dar.
Es ergeben sich somit entsprechende neue 12schrittige Codeworte.

In Fig. 5 sind die digitalisierten Spannungswerte an der Ausgangsleitung 13 in Fig. 2 gezeigt, die den einzelnen 128 Pixeln entsprechen. Es zeigt sich deutlich eine Hüllkurve, aus der sich das augenblicklich gelesene Codewort ermitteln läßt, welches wiederum den gerade gemessenen Drehwinkel der Codierscheibe 6 beschreibt. Um das Codewort wiederzugewinnen, werden die nebeneinanderliegenden Spannungswerte differenziert (Fig. 6) und die Extremwerte der Differenzierungskurve nach Fig. 6 bilden die Kantenpositionen für das verarbeitete Codewort. In Fig. 7 wurde unter die umgeformten Pixelspannungen der jeweilige digitale Wert des 12schrittigen Codeworts geschrieben. Das Codewort gibt auf 2° genau die Winkelstellung der Codierscheibe 6 an. Allerdings ist es möglich, den gemessenen Winkel noch erheblich genauer zu bestimmen, indem man die Verschiebung des Codeworts auf der Achse gegenüber einer Nullage berechnet. Wie aus Fig. 6 ersichtlich, ist das Codewort 7 ein Stück nach rechts verschoben, da einem einzelnen Codierfeld 7,8 etwa reichlich 10 Pixel entsprechen. Aus der Verschiebung des Codeworts in Fig. 7 gegenüber der Nullage läßt sich angeben, ob nun der tatsächliche Winkel der Codierscheibe etwas größer oder etwas kleiner als der vorher grob bestimmte 2°-Wert ist. Hierdurch lassen sich mögliche Auflösungen von etwa 0,1° erreichen, indem man die Verschiebung des Codeworts gegenüber der CCD-Zeile 10 berücksichtigt. Für die Erfindung wichtig ist auch, daß der verwendete Maximalcode nur ein Ausschnitt eines 4.096 umfassenden Codeworts ist, wobei der gewählte Ausschnitt 180 Codeworte umfaßt. Hierdurch ergibt sich ohne Berücksichtigung anderer Informationen eine hohe Wahrscheinlichkeit, auftretende Fehler zu erkennen, nämlich eine Wahrscheinlichkeit von 96 % (W = 4.096 - 180 : 4.096 = 0,96). Eine weitere Optimierung des Codes bis hin zur 100 %igen Fehlererkennungswahrscheinlichkeit ist möglich durch Berücksichtigung anderer Kriterien wie z.B. minimale Hamming-Distanz.

### Übersicht

**Einleitung:** Häufig werden bei digitalen Sensoren zur Lenkradwinkelbestimmung diskrete optische bzw. magnetische Bauelemente verwendet. Die erreichbare Auflösung ist im wesentlichen von der Anzahl und der Positioniergenauigkeit der verwendeten Sensoren, der mechanischen Randbedingungen sowie der Toleranzsituation abhängig und oftmals nicht ausreichend. Zur Erhöhung der Auflösung kann ein oben beschriebenes optisches Prinzip verwendet werden, das auf einer CCD (Charge-Coupled-Device) - Zeile basiert.

Bei einer CCD-Zeile handelt es sich um einen optischen Sensor, der aus einer großen Zahl (z.B. 64, 128, 256, 1024, ...), in einem Gehäuse linear angeordneter Sensorelemente besteht. Die der Grauwertinformation entsprechenden Sensorspannungen bzw. -ströme können mit Hilfe externer und bereits integrierter Elektronik ausgelesen werden. Infolge der hohen Pixelzahl ist eine Verarbeitung der Datensätze im Mikroprozessor gemäß digitaler Bildverarbeitung möglich, wodurch u.a. eine sehr feine Winkelbestimmung erreicht werden kann.

**Funktionsprinzip:** Der gesamte Sensor besteht im wesentlichen aus einer Lichtquelle, einer codierten Scheibe (o.ä.), der CCD-Zeile und der Auswerteelektronik. Aus der codescheibenbedingten Grauwertverteilung auf dem optosensitiven Bereich der Zeile wird die Lenkradwinkelposition bestimmt.

Bei Verwendung einer Codescheibe kann die CCD-Zeile sowohl tangential wie auch radial zu dieser positioniert werden.
Bei tangentialer Anordnung befindet sich der Code (z. B. Maximalcode) am Umfang der Codescheibe, bei radialer Montage ist der Code (z.B. Graycode) kreisringförmig in der Scheibe zu integrieren. Alternativ zur Nutzung einer Codescheibe kann zur Platzreduzierung die Codierung auf andere Komponenten (z.B. Lenksäule; axiale und tangentiale Sensorposition möglich) aufgebracht werden. Abhängig von den Randbedingungen bezüglich der Konstruktion, der Verschmutzungsproblematik, etc. ist das Durchlicht- bzw. das Reflexionsprinzip zu bevorzugen.

Zur einfachen Fertigung und zur Verbesserung der Schmutzunempfindlichkeit sind möglichst "grobe" Codestrukturen (breite 0-1-Infos) zu verwenden. Bei Nutzung einer Codescheibe mit tangentialer Sensorposition kann der Absolutwinkel über den eigentlichen Code grob bestimmt werden. Eine feine Winkelauflösung wird erreicht, indem z.B. die Kanten der 0-1-Übergänge oder die Schwerpunkte der Hell- und Dunkelfelder ermittelt und ausgewertet werden.

Die Abtastdauer der Codierung mit der CCD-Zeile ist nicht beliebig zu verkürzen. Die sich dadurch bei schneller Lenkraddrehung auf der Zeile ergebenden unscharfen Grauwertübergänge können verbessert werden, indem die Lichtquelle nicht im Dauerbetrieb sondern gepulst verwendet wird. Die Einschaltzeitpunkte sind dabei mit dem Abtast- und Auslesetiming zu synchronisieren (z.B. Ansteuerung der Lichtquelle mit dem Mikro-Controller).

Mit geeigneten Software-Algorithmen sind Toleranzen (z.B. Positionierungsgenauigkeit des Sensors, Radial- und Taumelbewegung der Codescheibe, Alterung der Lichtquelle, ...) nicht vorhanden bzw. in gewissen Grenzen kompensierbar. Zusätzlich sind Fehlererkennungsmechanismen integrierbar.

Die Abbildung zeigt ein mögliches Konzept der Auswertelektronik. Hierbei werden die Grauwertinformationen der optischen Sensoren der CCD-Zeile, gesteuert durch den Mikro-Controller, sequentiell aus-, mit einem A/D-Converter digitalisiert und anschließend in den Controller eingelesen. Bei schnellen Umsetzzeiten wird ein externer A/D-Wandler erforderlich sein, bei geringeren Taktfrequenzen genügt der in dem Controller integrierte Converter. Der nach dem Auslesevorgang vollständig im Mikro-Controller zur Verfügung stehende Datensatz wird anschließend mit entsprechender Software ausgewertet. Ist die Verarbeitung der Grauwertinformation abgeschlossen, beginnt das Auslesen des nächsten Datensatzes.

Generell ist die Nutzung einer CCD-Zeile nicht nur in der Lenkwinkelsensor-Anwendung denkbar. Sie kann allgemein für lineare und rotatorische Positionserkennungen eingesetzt werden.

Wie erwähnt, wird zur Minimierung der für die Digitalisierung erforderlichen Zeit ein schneller externer A/D-Wandler (ADU) benötigt (der im Mikrocontroller integrierte ADU ist relativ langsam). Zur Einsparung des kostenintensiven externen ADUs ist folgendes Verfahren möglich: Während der bereits im vorherigen Zyklus eingelesene Datensatz ausgewertet wird, wird dazu parallel die einzelnen Analogwerte des nächsten Datensatzes im Mikrocontroller-internen A/D-Wandler "langsam" digitalisiert und gespeichert. D.h. nachdem ein Digitalisierungsprozeß abgeschlossen ist, wird durch einen Interrupt die Auswerteroutine des Datensatzes unterbrochen, der nun zur Verfügung stehende digitalisierte Wert gespeichert, die Wandlung des nächsten Analogwertes gestartet und mit der zuvor abgebrochenen Routine fortgefahren. Dies wird solange wiederholt, bis alle Analogwerte eines Datensatzes digitalisiert sind.

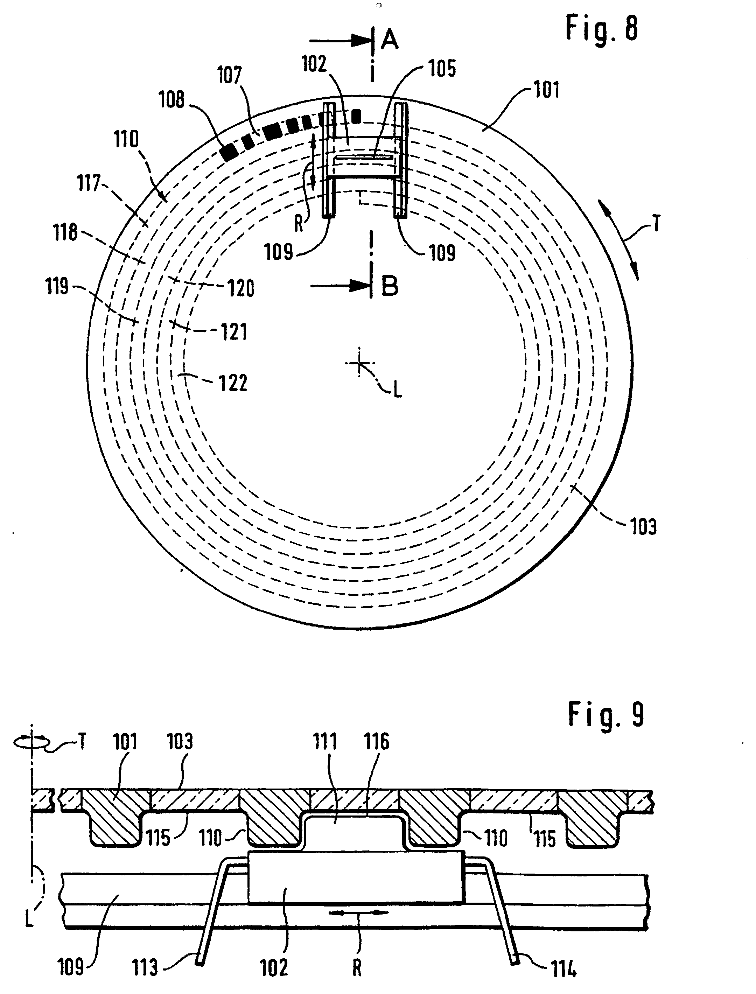

Fig. 8 zeigt als Codierelement eine Codescheibe 101, deren Drehwinkel ermittelt werden soll. Unterhalb der Codescheibe 101 ist eine CCD-Zeile angeordnet. Wie dies weiter vorn beschrieben wurde. Die Arbeitsweise der CCD-Zeile in Verbindung mit einer Codierscheibe wurde bereits in der Application Brief der Firma Texas Instruments "linear products, TSL 214 integrated Opto-Sensor" beschrieben, die den Opto-Sensor TSL 214 der Firma Texas Instruments betrifft. Die Codierscheibe 101 ist mit einer spiralförmigen Codespur 103 versehen, auf der ein fortlaufender Maximalcode über alle sechs Windungen angebracht ist. Dieser Maximalcode zeichnet sich dadurch aus, daß er eine fortlaufende Codierung erhält, wobei schrittweise mehrschrittige (beispielsweise 14schrittige) Codeworte ausgelesen werden können und die einzelnen auslesbaren Codeworte über alle sechs Spuren sich nicht wiederholen (näheres hierzu auch weiter vorn in dieser Patentanmeldung).

In Fig. 9 ist somit nur ein kurzer Ausschnitt der gesamten Codierung gezeigt.

Die CCD-Zeile 102 ist mit einer Reihe (105) von nebeneinanderliegenden lichtempfindlichen Elementen (sog. Pixel) ausgestattet, durch welche das gerade abgetastete Codewort ausgelesen wird. Die Codierung arbeitet nach dem sog. Durchlichtprinzip, d.h. oberhalb der Betrachtungsebene von Fig. 8 befindet sich eine Lichtquelle, welche die lichtdurchlässigen Codierfelder 107 durchleuchtet, während die undurchsichtigen Codierfelder 108 kein Licht zu der Pixel-Reihe 105 durchlassen. Hierdurch ergibt sich eine Lichtverteilung auf der Pixel-Reihe, durch welches das von der Drehwinkellage der Codescheibe abhängige Codewort über die Pixtel-Reihe 105 gelesen werden kann. Für die Erfindung besonders wichtig ist nun ein sich in radialer Richtung erstreckender Schlitten 109, durch welchen die CCD-Zeile 102 in radialer Richtung führbar ist. Schlitten und CCD-Zeile befinden sich unterhalb der Codescheibe 101.

In Fig. 2 ist nun die Codescheibe 101 stark vergrößert im Schnitt dargestellt, wobei sich die Scheibe um die Längsachse L in Drehrichtung T (siehe auch Fig. 8) dreht. Der in Fig. 9 gezeigte Schnitt verläuft dabei entlang der Schnittlinie A-B in Fig. 8. Die Codescheibe 101 ist mit einer spiralförmigen Nut 110 versehen, in welche ein entsprechender Vorsprung 111 an der CCD-Zeile 102 eingreift. Vergleichbar mit dem Tonkopf eines Plattenspielers wird somit die CCD-Zeile beim Drehen der Codescheibe 101 in Abhängigkeit von der Drehrichtung T in Bewegungsrichtung R nach rechts oder links gefördert. Am Boden der spiralförmigen Nut 110 sind die undurchsichtigen bzw. durchsichtigen Codefelder 107,108 eingearbeitet, wobei sie durch eine nicht dargestellte oberhalb der Codescheibe in Fig. 8 und 9 befindliche Lichtquelle angestrahlt werden. Die die Codefelder durchdringende Strahlung wird mit der Pixel-Reihe 105 erkannt und das somit gelesene Codewort identifiziert, wodurch sich der Drehwinkel der Codescheibe 101 bestimmen läßt. Das identifizierte Codewort beschreibt aber nicht nur den absoluten Drehwinkel der Scheibe, sondern auch die gerade gültige Umdrehungszahl. Die ermittelten Codeworte bzw. die zur Ermittlung der Codeworte notwendigen Spannungswerte der einzelnen Pixels können an den Anschlüssen 113,114 abgegriffen werden.

Um mittels der Leseeinrichtung der einzelnen Codeworte lesen zu können, ist es notwendig, eine Lichtquelle vorzusehen. Diese Lichtquelle kann im einfachsten Fall das gesamte Codierelement im wesentlichen gleichmäßig ausleuchten, so daß alle Codeworte theoretisch lesbar sind, aber nur dasjenige Codewort gelesen wird, welches sich aus der augenblicklichen Position der Leseeinrichtung durch diese lesen läßt. Bei dieer großflächigen Ausleuchtung des Codierelements kann die Lichtquelle ortsfest angeordnet sein. Dabei eignet sich sowohl das Durchlichtprinzip als auch das Reflexlichtprinzip, d.h. die Leseeinrichtung wertet entweder die durch das Codierelement hindurchtretende Strahlung oder die durch das Codierelement reflektierte Strahlung aus. Eine weitere Möglichkeit besteht darin, die Lichtquelle parallel zu der Leseeinrichtung zu führen, wobei im wesentlichen der die Leseeinrichtung umgebende Bereich des Codierelements ausgeleuchtet wird und wiederum das Durchlicht- oder Reflexlichtprinzip angewendet werden kann. Bei dieser Ausgestaltung wird die Lichtquelle vorzugsweise beweglich angeordnet. Dies gilt zumindest für die direkte Beleuchtung des Codierelements. Eine andere Möglichkeit kann darin bestehen, die Lichtquelle auch in diesem Fall zwar ortsfest anzuordnen, das Licht aber beispielsweise über einen Lichtleiter der Positionsänderung des Leseelements nachzuführen.

### Übersicht

Die bisherigen Systeme zur Erfassung des absoluten Lenkradwinkels sind prinzipiell, unabhängig vom gewählten physikalischen Sensorprinzip (z.B. optisch, magnetisch), auf einen Winkelbereich von 0 - 360° beschränkt. Liegt eine Lenkraddrehung vor, die diesen Bereich überschreitet, wird, entsprechend der periodischen Fortsetzung, nur der Absolutwinkel in dem Wertebereich [0 - 360°] erkannt. Ist ein Absolutwinkel mit entsprechender Umdrehungszahl n mit

$$\alpha = n * 360° + \alpha'$$

gewünscht, ist eine zusätzliche Sensoreinheit, bestehend z.B. aus Spezialgetriebe, Sensorik und Elektronik, erforderlich. Diese Zusatzeinheit ermittelt die Umdrehungszahl n, wobei über Software schließlich α berechenbar ist.

Inhalt dieser Anmeldung ist ein Sensorprinzip, mit dem, bei Verwendung von nur einer Sensoreinheit (z.B. foto- oder mangetosensitiver Zeile), der Absolutwinkel, inklusive der Umdrehungszahl, ermittelt werden kann. Ein derartiges Verfahren ist nicht nur zur Bestimmung des Lenkradwinkels verwendbar, es kann für alle Applikationen eingesetzt werden, bei denen der Absolutwinkel über einen Bereich von mehreren Umdrehungen bestimmt werden soll.

**Sensorprinzip:** Wesentliches Prinzip dieses absoluten Winkelmeßsystems ist eine auf eine Codescheibe spiralförmig aufgebrachte Codespur mit mehreren Windungen (die Anzahl der Codespurwindungen entspricht der Umdrehungszahl des zu detektierenden Winkelbereiches). Dieser Code wird über eine Sensorzeile geführt. Abhängig von der Umdrehungszahl befindet sich diese Zeile aufgrund einer geeigneten mechanischen Mitnahme und Führung an der entsprechenden Windung der spiralförmigen Codespur.

Bei dem auf der Codespur aufgebrachten Code handelt es sich um einen nach verschiedenen Kriterien optimierten Maximalcode. D.h. die jeweilige auf der Sensorzeile abgebildete Bitkombination existiert im gesamten Winkelmeßbereich nur unikativ.

**Realisierungsmöglichkeiten:** Die Codespurspirale kann auf verschiedene Weise integriert werden: Mögliche Varianten wären die Aufbringung auf eine planare Scheibe (Bewegungsrichtung der Sensorzeile: radial zur Lenksäule) oder Integration auf den Mantel eines rotationssymmetrischen Zylinders (Bewegungsrichtung der Sensorzeile: axial zur Lenksäule). Exemplarisch ist in der angefügten Abbildung eine Konstruktionsmöglichkeit dargestellt, die eine Scheibe mit spiralförmiger Codespur, die Sensorzeile, die radiale Sensorführung und die mechanische Mitnahmemöglichkeit des Sensors enthält.

Für die Mitnahme des Sensors sind unterschiedliche Mechaniken denkbar: Wie im Konstruktionsbeispiel dargestellt, sind zwischen den Codespurwindungen Stege vorgesehen, welche das Sensorelement in radialer Richtung mitnehmen. Ebenso ist die Mitnahmemöglichkeit bei Codespuranbringung auf der Mantelfläche eines Kreiszylinders durch derartige Stege denkbar. Anstelle der hier gezeigten Stegen sind andere Varianten (z.B. Nuten) für die Mitnahme möglich. Die Sensorbewegung kann alternativ auch mit einem Getriebe realisiert werden. Das in der Abbildung dargestellte Beispiel stellt das von der konstruktiven Seite her gesehen einfachste Realisierungsprinzip dar. Je nach Applikation müssen die einzelnen hier aufgezählten Möglichkeiten gegeneinander abgewogen werden.

Als Sensorelement ist die auf dem fotoelektrischen Effekt basierende CCD- (Charge Coupled Device) Zeile prädestiniert. Denkbar sind ebenso linear angereihte, diskrete optische Sensoren (z.B. Opto-Array) oder magnetische Sensorelemente, die ebenfalls in einer Linie angeordnet sind. Die geometrischen Abmessungen der Anreihung und die Anzahl der benötigten Sensorelemente sind mit dem Code abzustimmen.

Bei Verwendung des optischen Sensorprinzips (z.B. CCD-Zeile) eignen sich sowohl das Durchlicht- wie auch das Reflexlichtprinzip, wobei aus Gründen der Störunanfälligkeit das Durchlichtprinzip zu bevorzugen ist (durch Schmutz, Anlaufen, Alterung etc. reduziert sich der 0-1-Pegelabstand beim Reflexlichtprinzip). Die Lichtquelle kann bei beiden Verfahren entweder mit der Sensorbewegung geführt werden (fokussierter Lichtstrahl) oder aber der gesamte durch den Sensor überstrichene Bereich wird großflächig ausgeleuchtet. Ist aus Konstruktionsgründen die Position der Lichtquelle eingeschränkt, kann das Licht über einen Kunststofflichtleiter geführt werden, wobei, z.B. zur Erzeugung einer definierten Lichtverteilung in der Lichtaustrittsöffnung des Leiters eine Linsencharakteristik implementiert werden kann. Zur Erhöhung der Kantenschärfe, auch bei schneller Lenkraddrehung, und zur Kompensation von Helligkeitsschwankungen (z.B. Alter) arbeitet die Lichtquelle im adaptiven Pulsbetrieb.

**Vorteile des Verfahrens:** Absolutwinkel für großen Wertebereichmöglich: z.B. $\pm$ 1080° bei 6 Codespurwindungen. Keine zusätzliche Sensorik und Auswertung für die Umdrehungszahl erforderlich. Bei Nutzung einer CCD-Zeile und geeigneter Auswertealgorithmen sind hohe Auflösungen zu erreichen. Relativ einfache Konstruktion. Geringer Platzbedarf.

**Patentansprüche**

1. Positionssensor, insbesondere Drehwinkelsensor zur Lenkwinkelmessung von Kraftfahrzeugen, bei dem der auf eine CCD-Zeile (10) auftreffende Lichtstrom (L) einer Lichtquelle (5) durch ein Codierelement (6) in Abhängigkeit von der Position des Codierelementes (6) gesteuert wird und bei dem eine Auswerteeinrichtung (V, 12, 4) aufgrund der augenblicklichen Lichtverteilung auf der CCD-Zeile (10) die Position des Codierelements (6) bestimmt, **dadurch gekennzeichnet, dass** die Lichtquelle (5) pulsweise eingeschaltet wird und der Einschaltzeitpunkt der Lichtquelle (5) mit dem Abtastzeitpunkt und dem Auslesetiming synchronisiert wird.

2. Positionssensor nach Anspruch 1, **dadurch gekennzeichnet, dass** die Lichtquelle (5) mit der maximalen Nennleistung für Impulsbetrieb betrieben wird.

3. Positionssensor nach Anspruch 1 oder 2, **dadurch gekennzeichnet, dass** die Lichtquelle (5) zyklisch eingeschaltet wird und die Einschaltzeit kleiner als 5 % insbesondere 1 % der Zykluszeit ist.

**4.** Positionssensor nach einem der vorangegangenen Ansprüche, **dadurch gekennzeichnet, dass** das Codierelement (6) mit Codierfeldern (7, 8) versehen ist, die im wesentlichen lichtdurchlässig oder lichtundurchlässig sind, wobei mehrere derartiger Codierfelder (7, 8) abhängig von der Position des Codierelements (6) die Verteilung des von der Lichtquelle (5) zu der CCD-Zeile (10) auf einzelne Pixel (11) fallenden Lichtstroms (L) bestimmen.

**5.** Positionssensor nach einem der vorangegangenen Ansprüche, **dadurch gekennzeichnet, dass** das Codierelement (6) eine Codierscheibe ist und die Codierfelder (7, 8) vorzugsweise im wesentlichen durch aneinandergrenzende Kreissektoren mit gleichem Sektorwinkel oder Abschnitte dieser Sektoren sind.

**6.** Positionssensor nach Anspruch 5, **dadurch gekennzeichnet, dass** die Codierfelder (6) einander folgend auf einem geschlossenen Ring angeordnet sind, der sich vorzugsweise auf einer Kreisscheibe befindet und die Codierzeile (11) tangential zu dem Ring ausgerichtet ist.

**7.** Positionssensor nach einem der vorangegangenen Ansprüche, **dadurch gekennzeichnet, dass** das Codierelement (6) die Form einer Kreisscheibe oder einer Mantelfläche eines Zylinders besitzt und dass die Codierfelder (7, 8) einander folgend auf mehreren konzentrischen Kreisringen angeordnet sind und dass die CCD-Zeile (10) derart angeordnet ist, dass sie über mehrere Kreisringe reicht, wobei die von der CCD-Zeile (10) abgetasteten Codierwerte vorzugsweise einem Gray-Code entsprechen.

**8.** Positionssensor nach einem der vorangegangenen Ansprüche, **dadurch gekennzeichnet, dass** die lichtdurchlässigen und lichtundurchlässigen Codierfelder (7, 8) in Form eines mehrschrittigen beispielsweise 12-schrittigen Maximalcodes angeordnet sind.

**9.** Positionssensor nach Anspruch 8, **dadurch gekennzeichnet, dass** der verwendete Maximalcode aus einer Folge von z.B. 180 Codeworten mit jeweils 12 Schritten besteht, die aus einem längeren Maximalcode mit z.B. einem Zug von 4.096 Codeworten der gleichen Schrittzahl ausgeschnitten sind.

**10.** Positionssensor nach Anspruch 8, **dadurch gekennzeichnet, dass** die Codewortfolge aus dem Codewortzug nach folgender Reihenfolge von Vorgaben ausgewählt sind:

a) die Codewortfolge muss wiederum einen in sich geschlossenen Maximalcode ergeben,
b) es sollen möglichst kurze Folgen von gleichartigen lichtdurchlässigen bzw. lichtundurchlässigen Codefeldern erscheinen,
c) es sollen möglichst viele Wechsel zwischen lichtdurchlässigen und lichtundurchlässigen Codefeldern sich ergeben,
d) es soll ein möglichst großer Hammingabstand benachbarter Codeworte vorliegen.

**11.** Positionssensor nach einem der vorangegangenen Ansprüche, **dadurch gekennzeichnet, dass** die Auswerteeinrichtung (V, 12, 4) die von der CCD-Zeile (10) abgegebenen Spannungsimpulse in entsprechende Digitalwerte umwandelt.

**12.** Positionssensor nach Anspruch 11, **dadurch gekennzeichnet, dass** die Auswerteeinrichtung den durch die Folge von Digitalwerten abgebildeten Kurvenverlauf nach die Kurve beschreibenden Merkmalen wie Kurvenflanken und/oder Extremwerten untersucht und danach die relative Lage des festgestellten Kurvenzugs gegenüber einer Normallage bestimmt (Grobwinkelbestimmung durch ermitteltes Codewort).

**13.** Positionssensor nach einem der vorangegangenen Ansprüche, **dadurch gekennzeichnet, dass** die Auswerteeinrichtung (V,12,4) mit einer Regeleinrichtung versehen ist, welche bei einem Absinken der maximalen Amplitudenwerte der gemessenen Spannungen an der Pixelzeile bzw. der entsprechenden Digitalwerte adaptiv die Sendeleistung bzw. die Lichtstärke der Lichtquelle (5) erhöht.

**14.** Positionssensor nach einem der vorangegangenen Ansprüche, **dadurch gekennzeichnet, dass** die Auswerteeinrichtung mit einem Mikrocontroller (4) versehen ist, dass der Mikrocontroller ein Rechenwerk und einen A-D-Wandler aufweist, die zeitlich parallel arbeiten und dass nach der Umwandlung eines Analogwertes in ein Digitalwert durch einen Interrupt die Berechnung des Kurvenverlaufs und deren Auswertung unterbrochen, ein Befehl zum Umwandeln des nachfolgenden Analogwerts solange gegeben werden bis alle Pixelspannungen digitalisiert und danach die Berechnung des vorherigen Datensatzes zu Ende geführt sind.

**15.** Positionssensor nach einem der vorangegangenen Ansprüche, **dadurch gekennzeichnet, dass** das Codierelement (6) an der Lenksäule eines Kraftfahrzeugs angeordnet ist und die Codierung nach dem Reflexionsprinzip gebildet ist.

**16.** Positionssensor nach einem der vorangegangenen Ansprüche, **dadurch gekennzeichnet, dass** wahlweise das Durchlichtprinzip oder das Reflexlichtprinzip angewendet wird.

**17.** Positionssensor nach einem der vorangegangenen Ansprüche, **dadurch gekennzeichnet, dass** der Positionssensor ein Drehwinkelsensor, insbesondere ein Lenkwinkelsensor für Kraftfahrzeuge mit einer im wesentlichen kreisförmig angeordneten Codespur ist, welche mit Codeworten versehen ist auf einem Codierelement (101), wobei der Drehwinkel aufgrund eines Codeworts (107, 108) bestimmt wird, welches durch die Leseeinrichtung (102) in Abhängigkeit von der Drehwinkelstellung des Codierelementes (101) gelesen wird und wobei Mittel vorgesehen sind, durch welche die von dem Codierelement (101) gegenüber einer Nullstellung eingenommene Umdrehungszahl feststellbar ist, wobei mehrere quer (in Richtung R) zur Abtastrichtung (Richtung T) angeordnete, im wesentlichen kreisringförmige Codespuren vorgesehen sind, und dass eine Transporteinrichtung (101, 111) vorgesehen ist, welche die Leseeinrichtung (102) in Abhängigkeit von der Umdrehungszahl gegenüber einer Nullstellung zu den einzelnen Codespuren befördert.

**18.** Drehwinkelsensor nach Anspruch 17, **dadurch gekennzeichnet, dass** die Codespuren (103) derart spiralförmig verbunden sind, dass die Gesamtcodespur eine Spirale ergibt.

**19.** Drehwinkelsensor nach Anspruch 17 oder 18, **dadurch gekennzeichnet, dass** die Codespur (103) auf einer Kreisscheibe oder auf der Mantelfläche eines Zylinders angeordnet ist.

**20.** Drehwinkelsensor nach einem der Ansprüche 17 bis 18, **dadurch gekennzeichnet, dass** zwischen dem Codierelement (101) und der Leseeinrichtung (102) Führungsmittel (110,111) vorgesehen sind, welche die Leseeinrichtung (102) quer (in Richtung R) zur Leserichtung (in Richtung T) der Codeworte fördern.

**21.** Drehwinkelsensor nach Anspruch 20, **dadurch gekennzeichnet, dass** die Führungsmittel aus einer Nut-Vorsprung-Verbindung bestehen, wobei das dem Codierelement (101) zugeordnete Verbindungsmittel (101) spiralförmig angeordnet ist.

**22.** Drehwinkelsensor nach einem der vorangegangenen Ansprüche, **dadurch gekennzeichnet, dass** das Codierelement (101) eine Codescheibe und das der Codescheibe zugeordnete Führungsmittel eine spiralförmige Nut (101) ist, und dass die Codierung (107,108) am Boden der Nut und die Leseelemente (105) der Leseeinrichtung (102) an der dem Nutboden (115) zugewandten Fläche (116) des Vorsprungs (111) an der Leseeinrichtung (102) angeordnet sind.

**23.** Drehwinkelsensor nach einem der vorangegangenen Ansprüche, **dadurch gekennzeichnet, dass** die Codierung ein Maximalcode ist, der sich über die gesamte spiralförmige Codespur (103) erstreckt.

**24.** Drehwinkelsensor nach einem der vorangegangenen Ansprüche, **dadurch gekennzeichnet, dass** die Leseeinrichtung (102) eine CCD-Zeile ist, die tangential (T) zu den im wesentlichen kreisförmig angeordneten Codespuren (117 bis 122) ausgerichtet ist.

**25.** Drehwinkelsensor nach einem der vorangegangenen Ansprüche, **dadurch gekennzeichnet, dass** das Codierelement durch eine ortsfeste Lichtquelle ausgeleuchtet wird, wobei das Durchlichtprinzip oder das Reflexlichtprinzip Anwendung findet.

**26.** Drehwinkelsensor nach einem der Ansprüche 17 bis 25, **dadurch gekennzeichnet, dass** die Lichtquelle beweglich angeordnet ist und einen Teil des Codierelements im Bereich der Leseeinrichtung direkt ausleuchtet oder dass die Lichtquelle ortsfest angeordnet ist und der im Bereich der Leseeinrichtung befindliche Teil des Codierelements über einen nachgeführten Lichtleiter indirekt ausgeleuchtet wird.

**Claims**

**1.** Position sensor, in particular angle of rotation sensor for measuring the steering angle of motor vehicles, in which the light current (L) of a light source (5) impinging on a CCD line (10) is controlled by a coding element (6) as a function of the position of the coding element (6) and in which an evaluation device (V, 12, 4) determines the position of the coding element (6) on the basis of the momentary light distribution on the CCD line (10), **characterised in that** the light source (5) is switched on by means of pulses and the switch-on time of the light source (5) is synchronised with the scanning time and the timing of the read-out.

**2.** Position sensor according to claim 1, **characterised in that** the light source (5) is operated at the maximum nominal power for pulse operation.

**3.** Position sensor according to claim 1 or 2, **characterised in that** the light source (5) is switched on in cycles and the switch-on time is less than 5%, in particular 1% of the cycle time.

**4.** Position sensor according to one of the preceding claims, **characterised in that** the coding element (6) is provided with code fields (7, 8) which are substantially transparent or opaque, wherein several code fields (7, 8) of this kind determine the distribution of the light current (L) incident from the light source (5) to the CCD line (10) onto individual pixels (11), depending on the position of the coding element (6).

5. Position sensor according to one of the preceding claims, **characterised in that** the coding element (6) is a code disk and the code fields (7, 8) are preferably substantially mutually adjacent circular sectors with identical sector angle or portions of these sectors.

6. Position sensor according to claim 5, **characterised in that** the code fields (6) are arranged in succession to one another on a closed ring, which is preferably located on a circular disk, and the code line (11) is aligned tangentially to the ring.

7. Position sensor according to one of the preceding claims, **characterised in that** the coding element (6) is in the form of a circular disk or an outer casing face of a cylinder and **in that** the code fields (7, 8) are arranged in succession to one another on several concentric circular rings and **in that** the CCD line (10) is arranged in such a way that it reaches across several circular rings, the coding values scanned by the CCD line (10) preferably corresponding to a Gray code.

8. Position sensor according to one of the preceding claims, **characterised in that** the transparent and opaque code fields (7, 8) are arranged in the form of a multi-step, for example, 12-step, maximum code.

9. Position sensor according to claim 8, **characterised in that** the maximum code used consists of a series of, e.g. 180 code words with 12 steps in each case, which are extracted from a longer maximum code with, e.g. a succession of 4.096 code words with the same number of steps.

10. Position sensor according to claim 8, **characterised in that** the code word series is selected from the succession of code words according to the following order of presets:

a) the code word series must again result in a self-contained maximum code,
b) the shortest possible series of homogenous transparent or opaque code fields should appear,
c) as many changes as possible between transparent and opaque code fields should arise,

d) there should be as large a Hamming distance of adjacent code words as possible.

11. Position sensor according to one of the preceding claims, **characterised in that** the evaluation device (V, 12, 4) transforms the voltage pulses delivered by the CCD line (10) into corresponding digital values.

12. Position sensor according to claim 11, **characterised in that** the evaluation device examines the course of the curve depicted by the series of digital values for features describing the curve, such as curve flanks and/or extreme values and according to these determines the relative position of the characteristic of the curve established in respect of a normal position (rough determination of angle by means of detected code word).

13. Position sensor according to one of the preceding claims, **characterised in that** the evaluation device (V, 12, 4) is provided with a regulating device which adaptively increases the transmitting power or the light intensity of the light source (5) when the maximum amplitude values of the measured voltages on the pixel line or the corresponding digital values drop.

14. Position sensor according to one of the preceding claims, **characterised in that** the evaluation device is provided with a microcontroller (4), **in that** the microcontroller has an arithmetic unit and an A/D transformer, which operate chronologically in parallel and **in that**, after transformation of an analog value into a digital value, calculation of the course of the curve and its evaluation are interrupted by an interrupt, a command for transforming the subsequent analog value is given until all the pixel voltages have been digitised and then calculation of the previous data set is brought to an end.

15. Position sensor according to one of the preceding claims, **characterised in that** the coding element (6) is arranged on the steering column of a motor vehicle and the coding is formed according to the reflection principle.

16. Position sensor according to one of the preceding claims, **characterised in that** the transmitted light principle or the reflex light principle is optionally applied.

17. Position sensor according to one of the preceding claims, **characterised in that** the position sensor is an angle of rotation sensor, in particular a steering angle sensor for motor vehicles with a code track substantially arranged as circular, which is provided with code words on a coding element (101), wherein the angle of rotation is determined on the basis of a code word (107, 108), read by the reading device (102) as a function of the position of the angle of rotation of the coding element (101), and wherein means are provided, by which the number of revolutions per minute taken up by the coding element (101) in respect of a zero position can be established, wherein several substantially annular code tracks arranged transversely (in direction R) to the scanning direction (direction T) are provided, and **in that** a transport device (101, 111) is provided which conveys the reading device (102) to the individual code tracks as a function of the number of revolutions per minute in respect of a zero position.

18. Angle of rotation sensor according to claim 17, **characterised in that** the code tracks (103) are connected in a spiral-shape in such a way that the overall code track results in a spiral.

19. Angle of rotation sensor according to claim 17 or 18, **characterised in that** the code track (103) is arranged on a circular disk or on the outer casing face of a cylinder.

20. Angle of rotation sensor according to one of claims 17 to 18, **characterised in that**, between the coding element (101) and the reading device (102), guide means (110, 111) are provided which convey the reading device (102) transversely (in direction R) to the reading direction (in direction T) of the code words.

21. Angle of rotation sensor according to claim 20, **characterised in that** the guide means consist of a groove-projection connection, the connecting means (110) assigned to the coding element (101) being arranged in a spiral shape.

22. Angle of rotation sensor according to one of the preceding claims, **characterised in that** the coding element (101) is a code disk and the guide means assigned to the code disk is a spiral-shaped groove (110) and **in that** the coding (107, 108) is arranged on the floor of the groove and the reading elements (105) of the reading device (102) are arranged on the reading device (102) on the face (116) of the projection (111) facing the floor of the groove (115).

23. Angle of rotation sensor according to one of the preceding claims, **characterised in that** the coding is a maximum code extending over the entire spiral-shaped code track (103).

24. Angle of rotation sensor according to one of the preceding claims, **characterised in that** the reading device (102) is a CCD line aligned tangentially (T) to the code tracks (117 to 122) arranged substantially as circular.

25. Angle of rotation sensor according to one of the preceding claims, **characterised in that** the coding element is illuminated by a stationary light source, the transmitted light principle or the reflex light principle being applied.

26. Angle of rotation sensor according to one of claims 17 to 25, **characterised in that** the light source is arranged as mobile and directly illuminates a part of the coding element in the region of the reading device or **in that** the light source is arranged as stationary and the part of the coding element located in the region of the reading device is indirectly illuminated via a tracked light conductor.

## Revendications

1. Capteur de position, notamment capteur d'angle de rotation pour la mesure de l'angle de direction de véhicules automobiles, dans lequel le flux lumineux (L) d'une source lumineuse (5) qui atteint une barrette (10) d'éléments CCD est dirigé par un élément de codage (6) en fonction de la position de l'élément de codage (6), et dans lequel un équipement d'interprétation (V, 12, 4) détermine la position de l'élément de codage (6) sur la base de la répartition momentanée de la lumière sur la barrette (10) d'éléments CCD, **caractérisé en ce que** la source lumineuse (5) est activée de façon pulsée, et l'instant d'activation de la source lumineuse (5) est synchronisé avec l'instant de balayage et le timing de lecture.

2. Capteur de position selon la revendication 1, **caractérisé en ce que** la source lumineuse (5) est exploitée à la puissance nominale maximale pour le fonctionnement pulsé.

3. Capteur de position selon la revendication. 1 ou 2, **caractérisé en ce que** la source lumineuse (5) est activée cycliquement, et le temps d'activation est inférieur à 5 %, notamment à 1 %, du temps de cycle.

4. Capteur de position selon l'une des revendications précédentes, **caractérisé en ce que** l'élément de codage (6) est pourvu de champs de codage (7, 8) qui sont essentiellement translucides ou opaques, plusieurs champs de codage (7, 8) de ce type déterminant, en fonction de la position de l'élément de codage (6), la répartition sur des pixels individuels (11) de la barrette (10) d'éléments CCD du flux lumineux (L) provenant de la source lumineuse (5).

5. Capteur de position selon l'une des revendications précédentes, **caractérisé en ce que** l'élément de codage (6) est un disque de codage, et les champs de codage (7, 8) sont de préférence sensiblement des secteurs de cercle contigus de même angle de secteur, ou des parties de tels secteurs.

6. Capteur de position selon la revendication 5, **caractérisé en ce que** les champs de codage (6) sont disposés en succession sur un anneau fermé qui se trouve de préférence sur un disque circulaire, et la barrette de codage (11) est orientée tangentiellement à l'anneau.

7. Capteur de position selon l'une des revendications précédentes, **caractérisé en ce que** l'élément de codage (6) possède la forme d'un disque circulaire ou d'une surface extérieure d'un cylindre et **en ce que** les champs de codage (7, 8) sont disposés en succession sur plusieurs anneaux de cercle concentriques, et **en ce que** la barrette (10) d'éléments CCD est disposée de telle sorte qu'elle s'étend sur plusieurs anneaux de cercle, les valeurs de codage balayées par la barrette (10) d'éléments CCD correspondant de préférence à un code Gray.

8. Capteur de position selon l'une des revendications précédentes, **caractérisé en ce que** les champs de codage translucides et opaques (7, 8) sont disposés sous la forme d'un code maximal à plusieurs incréments, par exemple à 12 incréments.

9. Capteur de position selon la revendication 8, **caractérisé en ce que** le code maximal utilisé est constitué d'une succession de, par exemple, 180 mots de code ayant chacun 12 incréments, qui sont extraits d'un code maximal plus long comportant par exemple une série de 4 096 mots de code ayant chacun le même nombre d'incréments.

10. Capteur de position selon la revendication 8, **caractérisé en ce que** la succession de mots de code est choisie dans la série de mots de code d'après les consignes suivantes, dans cet ordre :

   a) la succession de mots de code doit à nouveau fournir un code maximal en soi fermé,
   b) des successions les plus courtes possible de champs de code de même type, translucides ou opaques, doivent être formées,
   c) on doit obtenir le plus possible d'alternances entre des champs de code translucides et des champs de code opaques,
   d) il doit exister une distance de Hamming maximale entre des mots de code voisins.

11. Capteur de position selon l'une des revendications précédentes, **caractérisé en ce que** l'équipement d'interprétation (V, 12, 4) transforme les impulsions de tension délivrées par la barrette (10) d'éléments CCD en valeurs numériques correspondantes.

12. Capteur de position selon la revendication 11, **caractérisé en ce que** l'équipement d'interprétation analyse l'allure de la courbe reproduite par la succession de valeurs numériques d'après des caractéristiques décrivant la courbe telles que des flancs de courbe et/ou des valeurs extrêmes, puis détermine la position relative, par rapport à une position normale, de la branche de courbe identifiée (détermination grossière de l'angle au moyen du mot de code obtenu).

13. Capteur de position selon l'une des revendications précédentes, **caractérisé en ce que** l'équipement d'interprétation (V, 12, 4) est doté d'un équipement de régulation qui, en cas de baisse des valeurs maximales d'amplitude des tensions mesurées sur la ligne de pixels, ou encore des valeurs numériques correspondantes, augmente de façon adaptative la puissance d'émission ou encore l'intensité lumineuse de la source lumineuse (5).

14. Capteur de position selon l'une des revendications précédentes, **caractérisé en ce que** l'équipement d'interprétation est pourvu d'un microcontrôleur (4), **en ce que** le microcontrôleur présente une unité de calcul et un convertisseur analogique-numérique qui travaillent en parallèle dans le temps, et **en ce que**, à la suite de la transformation d'une valeur analogique en une valeur numérique, le calcul de l'allure de courbe et son interprétation sont interrompus par une interruption, et un ordre pour transformer la valeur analogique suivante est donné jusqu'à ce que toutes les tensions de pixels soient numérisées, puis le calcul du jeu précédent de données est achevé.

15. Capteur de position selon l'une des revendications précédentes, **caractérisé en ce que** l'élément de codage (6) est disposé sur la colonne de direction d'un véhicule automobile, et le codage est formé selon le principe de réflexion.

16. Capteur de position selon l'une des revendications précédentes, **caractérisé en ce qu'**on utilise au choix le principe de lumière transmise ou le principe de lumière réfléchie.

17. Capteur de position selon l'une des revendications précédentes, **caractérisé en ce que** le capteur de position est un capteur d'angle de rotation, notamment un capteur d'angle de direction pour des véhicules automobiles avec une piste de code disposée essentiellement circulairement, qui est pourvue de mots de code sur un élément de codage (101), l'angle de rotation étant déterminé sur la base d'un mot de code (107, 108) qui est lu par l'équipement de lecture (102) en fonction de la position angulaire de rotation de l'élément de codage (101), et des moyens étant prévus par lesquels on peut déterminer le nombre de tours effectués par l'élément de codage (101) par rapport à une position zéro, plusieurs pistes de code essentiellement en forme d'anneau de cercle, disposées transversalement (direction R) à la direction de balayage (direction T) étant prévues, et **en ce qu'**il est prévu un équipement de transport (101, 111) qui transporte l'équipement de lecture (102) vers les pistes de code individuelles en fonction du nombre de tours par rapport à une position zéro.

18. Capteur d'angle de rotation selon la revendication 17, **caractérisé en ce que** les pistes de code (103) sont reliées en spirale de telle sorte que la piste de code globale constitue une spirale.

19. Capteur d'angle de rotation selon la revendication 17 ou 18, **caractérisé en ce que** la piste de code (103) est disposée sur un disque circulaire ou sur la surface extérieure d'un cylindre.

20. Capteur d'angle de rotation selon l'une des revendications 17 à 18, **caractérisé en ce que** des moyens de guidage (110, 111) sont prévus entre l'élément de codage (101) et l'équipement de lecture (102), moyens qui transportent l'équipement de lecture (102) transversalement (direction R) à la direction de lecture (direction T) des mots de code.

21. Capteur d'angle de rotation selon la revendication 20, **caractérisé en ce que** les moyens de guidage consistent en un assemblage à rainure et saillie, le moyen d'assemblage (110) associé à l'élément de codage (101) étant disposé en spirale.

22. Capteur d'angle de rotation selon l'une des revendications précédentes, **caractérisé en ce que** l'élément de codage (101) est un disque de code et le moyen de guidage associé au disque de code est une rainure en spirale (110), et **en ce que** le codage (107, 108) est disposé sur le fond de la rainure et les éléments de lecture (105) de l'équipement de lecture (102) sont disposés sur la face (116) de la saillie (111) prévue sur l'équipement de lecture (102) qui est tournée vers le fond de rainure (115).

23. Capteur d'angle de rotation selon l'une des revendications précédentes, **caractérisé en ce que** le codage est un code maximal qui s'étend sur la totalité de la piste de code (103) en forme de spirale.

24. Capteur d'angle de rotation selon l'une des revendications précédentes, **caractérisé en ce que** l'équipement de lecture (102) est une barrette d'éléments CCD qui est orientée tangentiellement (T) aux pistes de code (117 à 122) disposées essentiellement circulairement.

25. Capteur d'angle de rotation selon l'une des revendications précédentes, **caractérisé en ce que** l'élément de codage est éclairé par une source lumineuse fixe, en utilisant le principe de lumière transmise ou le principe de lumière réfléchie.

26. Capteur d'angle de rotation selon l'une des revendications 17 à 25, **caractérisé en ce que** la source lumineuse est disposée à déplacement et éclaire directement une partie de l'élément de codage dans la région de l'équipement de lecture, ou **en ce que** la source lumineuse est disposée fixement et la partie de l'élément de codage qui se trouve dans la région de l'équipement de lecture est éclairée indirectement par l'intermédiaire d'un conducteur de lumière ajusté.

Fig. 1

EP 0 862 728 B1

Fig.2

EP 0 862 728 B1

# Fig.3

Fig. 4

Fig. 5

Fig. 6

Fig. 7

Fig. 8

Fig. 9